# EUROPÄISCHE PATENTANMELDUNG

(11) **EP 3 902 020 A1**
(43) Veröffentlichungstag der Anmeldung: **27.10.2021**
(21) Anmeldenummer: 21179979.6
(22) Anmeldetag: 21.01.2015
(51) Int. Cl.: H01L 33/60, H01L 33/62, H05K 1/18, H05K 3/00

(54) **LEITERPLATTE**

(30) Priorität: 29.01.2014 AT 500582014
(62) Teilanmeldung aus: 15708697.6
(71) Anmelder: AT & S Austria Technologie & Systemtechnik Aktiengesellschaft, 8700 Leoben (AT)
(72) Erfinder: Langer, Gregor, 9061 Wölfnitz (AT); Damej, Mario, 9131 Grafenstein (AT); Lutschounig, Ferdinand, 9170 Ferlach (AT)
(74) Vertreter: Patentanwaltskanzlei Matschnig & Forsthuber OG

(57) **Zusammenfassung**

Die Erfindung betrifft eine Leiterplatte (1), wobei die Leiterplatte (1) an ihrer Leiterplattenoberfläche zumindest eine strukturierte Bondoberfläche (5) zum Ankontaktieren für optoelektronische Komponenten (12) aufweist, und wobei die Leiterplatte (1) zumindest eine Kavität (9) zur Aufnahme einer optoelektronischen Komponente (12) aufweist, wobei Kavitätenwände (10) in der zumindest einen Kavität (9) eine reflektierende, insbesondere spiegelnde, Reflektorschicht (11) aufweisen. Selektiv sind nur die Kavitätenwände (10) im Inneren der Kavität (9) mit der Reflektorschicht (11) beschichtet, wobei die Reflektorschicht (11) eine Lackbeschichtung ist.

## Beschreibung

Die vorliegende Erfindung betrifft eine Leiterplatte, die zumindest eine Kavität zur Aufnahme einer elektronischen Komponente umfasst, wobei die Kavitätenwände der zumindest einen Kavität eine reflektierende, insbesondere spiegelnde Reflektorschicht aufweisen.

Leiterplatten werden in der elektronischen Industrie zum hochintegrierten Verschalten elektronischer Komponenten auf engstem Raum verwendet. Neben der mechanischen Stützfunktion müssen Leiterplatten aufgrund der hohen Integration, die notwendig ist, um den Anforderungen der Miniaturisierung elektronischer Geräte gerecht zu werden, eine Reihe weiterer Funktionen erfüllen. Beispielsweise wird der Wärmeverteilung in der Leiterplatte bzw. die Ableitung von Wärme aus der Leiterplatte große Aufmerksamkeit geschenkt. Viele Anwendungen verwenden leistungsstarke LED-Komponenten, sogenannte Power-LEDs, die zunehmend auch in Kavitäten in der Leiterplatte selbst integriert werden. Die Integration einer LED in die Leiterplatte gestattet eine gute Ableitung der von der LED gebildeten Wärme in die Leiterplatte, wo eine effiziente Verteilung der Wärme erfolgen kann, um Hitzeschäden im Bereich der LED möglichst zu vermeiden. Nachteilig hierbei ist jedoch, dass durch die räumliche Umfassung der LED durch die Kavitätenwände die Effizienz der LED hinsichtlich der Lichtausbeute vermindert wird.

Es wäre somit wünschenswert, die Kavitäten bzw. die Kavitätenwände für LED-Anwendungen mit einer stark reflektierenden und insbesondere spiegelnden Reflektorschicht zu versehen. Problematisch hierbei ist jedoch, dass sämtliche zum Ausbilden derartiger Reflektorschichten im Rahmen einer industriellen Fertigung von Leiterplatten in Betracht zu ziehenden Verfahren zu einem mehr oder weniger unspezifischen Auftrag der die Reflektorschichten bildenden Materialien, z.B. Lacke, Pigmente und/oder Metalle, auf die Leiterplatte führen. So werden Lacke und Pigmente beispielsweise aufgesprüht, sodass zumindest die die Kavitäten umgebenden Bereiche mit dem Lack verschmutzt werden. Dies ist besonders bei Leiterplatten für LED-Anwendungen problematisch, da LED-Chips in der Regel durch Drahtbondverfahren ankontaktiert werden, welche Verfahren eine besondere Oberflächenbehandlung der Leiterplatte erfordern, um entsprechenden Bondoberflächen bereitzustellen. Diese Bondoberflächen müssen für das Bonden der Komponenten zum einen frei von Verschmutzungen oder gar Überlagerungen durch andere Schichten bleiben und sind andererseits mechanisch sehr empfindlich, sodass diese Flächen nach Ihrer Herstellung besser weitgehend unangetastet bleiben sollen.

Der Erfindung liegt daher die Aufgabe zugrunde, eine Leiterplatte anzugeben, bei der Reflektorschichten selektiv auf den Kavitätenwänden aufgebracht sind, ohne Leiterbahnenstrukturen und insbesondere Bondoberflächen zu beschädigen.

Eine Leiterplatte der eingangs genannten Art kann durch die folgenden Schritte eines Herstellungsverfahrens hergestellt werden:
- Bereitstellen einer Leiterplatte,
- Aufbringen einer temporären Schutzschicht auf zumindest einen Teilbereich der Oberfläche der Leiterplatte,
- Herstellen der Kavität unter Durchdringung der Schutzschicht im Bereich der Kavität,
- Aufbringen der Reflektorschicht, wobei die Reflektorschicht sowohl die temporäre Schutzschicht als auch die Kavitätenwände flächig bedeckt,
- Entfernen der temporären Schutzschicht.

Gemäß der vorliegenden Erfindung wird eine Leiterplatte vor der Herstellung der Kavität und somit auch vor dem Verspiegeln der Kavität mit einer temporären Schutzschicht versehen, die dazu gedacht ist, Leiterbahnen und vor allem empfindliche Bondoberflächen vor Beschmutzungen und Beschädigungen zu schützen. Da die temporäre Schutzschicht beim Herstellen der Kavität von dem entsprechenden Werkzeug durchdrungen wird, reicht die temporäre Schutzschicht exakt bis an den Rand der Kavität heran, sodass tatsächlich nur die Kavitätenwände mit der Reflektorschicht beschichtet werden. Die temporäre Schutzschicht wird nach Fertigstellung der verspiegelten Kavitäten entfernt, wodurch die empfindlichen Oberflächen wieder freigelegt und somit für die weitere Bearbeitung der Leiterplatte zur Verfügung stehen. In aller Regel erfolgt hierauf die Weiterverarbeitung in Form der Bestückung der verspiegelten Kavitäten mit den LED-Chips, die mittels Drahtbondverfahren ankontaktiert werden.

In diesem Zusammenhang kann das Verfahren zur Herstellung einer erfindungsgemäßen Leiterplatte bevorzugt dahingehend weitergebildet sein, dass eine Leiterplatte mit strukturierten Bondoberflächen für elektronische Komponenten bereitgestellt wird. Obwohl Bondoberflächen für elektronische Komponenten, wie beispielsweise LED-Chips, im Vergleich zu herkömmlichen Leiterzügen aus Kupfer relativ empfindlich sind und vor allem empfindlich gegenüber mechanischen Einflüssen sind, widerstehen sie dem Aufbringen und Entfernen einer temporären Schutzschicht ohne Weiteres und können nach dem Entfernen der temporären Schutzschicht zum Ankontaktieren mittels Drahtbondverfahren herangezogen werden.

Wie bereits eingangs erwähnt, entstehen in einer Leiterplatte aufgrund der hohen Integration der elektronischen Komponenten, die allesamt naturgemäß eine gewisse Abwärme produzieren und insbesondere bei Verwendung von leistungsstarken LED-Chips große Wärmemengen, die vor allem bei den genannten LED-Chips sehr punktuell auftreten und daher zur Vermeidung von Wärmespitzen in der Leiterplatte effektiv verteilt werden müssen, um eine akzeptable Lebensdauer der Leiterplatte zu gewährleisten. Gemäß einer bevorzugten Ausführungsform der vorliegenden Erfindung kann das Verfahren zur Herstellung einer erfindungsgemäßen Leiterplatte daher bevorzugt dahingehend weitergebildet sein, dass als Leiterplatte eine IMS-Leiterplatte bereitgestellt wird. Die Abkürzung IMS steht für Insulated Metal Substrate und bezeichnet Ausgangsmaterialen für Leiterplatten, bei denen eine Isolierschicht, beispielsweise bestehend aus mit thermisch leitfähigen Partikeln (z.B. Aluminiumoxid, Aluminiumnitrid) gefüllten Epoxidharz, zwischen einer dünnen Metallschicht zur Ausbildung der Leiterzüge und einer relativen dicken Metallplatte angeordnet ist, welche Metallplatte sehr effektiv Wärme über die gesamte Fläche der Platte verteilen kann. Die Verwendung einer IMS-Leiterplatte zur Aufnahme von LED-Chips in Kavitäten stellt somit hinsichtlich der Verteilung der Wärme eine überaus günstige Option dar, wobei jedoch dann, wenn die den LED-Chip enthaltende Kavität nicht erfindungsgemäß verspiegelt ist, eine relativ geringe Lichtausbeute resultiert. Dies liegt darin begründet, dass die Schnittflächen der Kavität, d.h. die Kavitätenwände, die in aller Regel aus Aluminium oder Kupfer bestehen, ein relatives geringes Reflexionsvermögen besitzen. Dieser Nachteil der Verwendung einer IMS-Leiterplatte zur Aufnahme von LED-Chips in Kavitäten wird somit mit der vorliegenden Erfindung optimal wettgemacht, da die per se schlecht reflektierenden bzw. gar nicht spiegelnden Kavitätenwände mit einer entsprechenden Reflektorschicht versehen werden können, ohne eventuell auf der Leiterplattenoberfläche vorhandene Bondoberflächen beim Herstellen der Reflektorschicht zu beschädigen.

Da es mit der vorliegenden Erfindung gelingt, eine hocheffiziente Reflektorschicht auf Kavitätenwände aufzubringen, ist es nicht notwendig, bei der Herstellung der Kavität, besondere Maßnahmen zur Optimierung des Reflexionsvermögens der Kavitätenwände zu ergreifen. Gemäß einer besonders einfachen und daher bevorzugten Ausführungsform der vorliegenden Erfindung kann somit insbesondere dergestalt vorgegangen werden, dass der Schritt des Herstellens der Kavität das Fräsen der Leiterplatte mit einem Fräskopf umfasst. Das Fräsen der Leiterplatte mit einem Fräskopf lässt sich in hervorragender Weise automatisieren, wobei der Fräskopf, der in der Lage ist, die Leiterplatte, und insbesondere eine IMS-Leiterplatte, zu fräsen, naturgemäß auch die temporäre Schutzschicht mit Leichtigkeit durchdringt und eine klare Schnittfläche der Schutzschicht herstellen kann, so dass eine optimale Begrenzung der Reflektorschicht auf die Kavitätenwände erreicht wird.

Gemäß einer bevorzugten alternativen Ausführungsform der vorliegenden Erfindung kann jedoch auch dergestalt vorgegangen werden, dass als Leiterplatte eine Leiterplatte aus einem Prepreg-Material bereitgestellt wird. Derartige Prepreg-Materialien, wie beispielsweise FR4, verfügen zwar über ein viel geringeres Wärmeleitvermögen als die vorgenannten IMS-Leiterplatten, sind jedoch weit verbreitet und bieten gegenüber IMS-Leiterplatten Vorteile hinsichtlich der relativ einfachen Realisierbarkeit von mehrschichtigen Leiterplattenaufbauten, was wiederum der in der elektronischen Industrie gewünschten Miniaturisierung der Leiterplatten entgegenkommt. Das Verfahren zur Herstellung einer erfindungsgemäßen Leiterplatte lässt sich ohne Weiteres auch auf derartige Leiterplatten aus Prepreg-Materialien anwenden.

In diesem Fall ist es bevorzugt, wenn der Schritt des Herstellens der Kavität das Schneiden der Leiterplatte mit einem Laserstrahl umfasst. Das Schneiden derartiger Leiterplatten mit einem Laserstrahl ist in der Leiterplattenindustrie ein gut erprobtes Standardverfahren und kann ohne Weiteres zur Herstellung von Kavitäten implementiert werden. Beispielsweise werden Prepreg-Leiterplatten mit CO2-Lasern geschnitten, wobei die Eindringtiefe des Lasers in die Leiterplatte durch das Vorsehen einer Laserstopplage aus Kupfer in der gewünschten Tiefe der Leiterplatte gesteuert werden kann. Der Laser muss somit nicht durch die Leiterplatte hindurch schneiden, sondern kann bis zu einer gewissen Tiefe schneiden, was das Laserschneidverfahren für das Ausbilden einer Kavität im Sinne einer Aushöhlung mit einem Boden in der Leiterplatte als Methode der Wahl erscheinen lässt.

Um das Ausbilden einer Kavität in einer derartigen Prepreg-Leiterplatte zu begünstigen, kann die Erfindung gemäß einer bevorzugten Ausführungsform dahingehend weitergebildet sein, dass die Leiterplatte eine über einer Laserstopplage angeordnete haftvermindernde Schicht aufweist. Wenn nun der Laser auf die Laserstopplage hin abschneidet und beispielsweise ein annähernd quaderförmiges Stück der Leiterplatte freistellt, kann dieses quaderförmige Stück durch die Wirkung der haftverminderten Schicht besonders leicht aus dem Volumen der Leiterplatte herausgenommen werden. In der Leiterplattentechnik sind derartige haftvermindernde Schichten bzw. haftvermindernde Materialien bekannt und bestehen insbesondere aus Al-, Mg-, Ca-, Na- oder Zn-Seifen zusammen mit einem Bindemittel und einem Lösungsmittel. Diese Materialien werden bereits standardmäßig verwendet, um Leiterplattenschichten, die frei geschnitten wurden, von den darunter liegenden Leiterplattenschichten zu lösen. Die Verwendung einer haftvermindernden Schicht ist beispielsweise aus der WO 2010/085830 A1 bekannt geworden.

Die für die Herstellung einer erfindungsgemäßen Leiterplatte so wesentliche temporäre Schutzschicht kann auf verschiedene Art und Weise auf die Leiterplatte aufgebracht werden. Gemäß einer bevorzugten Ausführungsform des Verfahrens zur Herstellung einer erfindungsgemäßen Leiterplatte kann jedoch vorgesehen sein, dass als temporäre Schutzschicht eine selbstklebende Folie aufgebracht wird, in welchem Fall die selbstklebende Folie bei nur geringem Druck und bei normaler Verarbeitungstemperatur der Leiterplatte auflaminiert werden kann.

Bevorzugt ist, dass die selbstklebende Folie eine Folie auf Polyethylenbasis mit einer Klebeschicht auf Kautschukbasis ist. Derartige Folien werden unter anderem als Laserschutzfolien verwendet und sind beispielsweise unter dem Namen Laserguard Light 3100H3 der Firma Nitto Denko bekannt. Ebenso fällt beispielsweise die Folie PF 32 C der Firma Poli-Film in diese Kategorie.

Gemäß einer alternativen bevorzugten Ausführungsform des Verfahrens zur Herstellung einer Leiterplatte gemäß der Erfindung kann die selbstklebende Folie eine Folie auf PVC-Basis mit einer Klebeschicht auf Acrylatbasis sein. Derartige Folien sind als Oberflächenschutzfolien bekannt, die sich durch hervorragende Verformungseigenschaften auszeichnen und zum Schutz von Metalloberflächen bei Verformungs- oder Biegeprozessen verwendet werden. In dieser Kategorie ist die Folie SPV 224P der Firma Nitto Denko zu nennen, welche eine PVC-Folie mit druckempfindlichen Acrylatkleber ist und welche Schmiereigenschaften beim Fräsen zur Verfügung stellt.

Gemäß einer weiters bevorzugten Ausführungsform des Verfahrens zur Herstellung einer Leiterplatte gemäß der Erfindung kann die selbstklebende Folie eine Folie auf Polyethylenbasis mit einer Klebeschicht auf Acrylatbasis sein, worunter beispielsweise die Folie PF 13 der Firma Poli-Film fällt.

Alle vorgenannten Folien werden in der Leiterplattenverarbeitung bereits standardmäßig eingesetzt und ihre Handhabung ist daher dem Fachmann geläufig.

Alternativ zu den vorgenannten selbstklebenden Folien ist jedoch auch eine Ausführungsform denkbar, bei der als temporäre Schutzschicht ein Lack auf Silikonbasis aufgebracht wird, der in einer dickeren Schicht aufgebracht werden und nach der Weiterverarbeitung der Leiterplatte, d.h. nach Herstellung der verspiegelten Kavitäten mechanisch durch Abziehen wieder entfernt werden kann.

Allen vorgenannten Varianten zur Bereitstellung bzw. zum Aufbringen einer temporären Schutzschicht ist gemeinsam, dass die Entfernung der temporären Schutzschicht mechanisch durch Abziehen erfolgen kann, da eine chemische Entfernung die Reflektorschicht in der Kavität und/oder die zu schützenden Oberflächen, und insbesondere die Bondoberflächen, angreifen würde.

Zur Herstellung der Reflektorschicht kann bevorzugt dergestalt vorgegangen werden, dass die Reflektorschicht aus einem Lack, ausgewählt aus der Gruppe bestehend aus Epoxidlacken und Acrylatlacken, gebildet wird. Epoxid- und Acrylatlacke sind ähnlich den in der Leiterplattenindustrie bekannten Lötstopplacken aufgebaut und können mit weißen Pigmenten oder Füllmaterialien gefüllt sein. Es können somit zum einen bekannte weiße Lötstopplacke verwendet werden, z.B. Lacke der Firmen Taiyo oder Huntsman (Probimer 77) oder speziell zum Ausbilden von Reflektorschichten hergestellt werden. Wesentlich ist jedoch, dass die Lacksysteme gegenüber UV-Licht und thermischer Belastung stabil sein müssen und nicht vergilben dürfen. Diese Lacke können mittels Sprühverfahren aufgebracht werden, wobei sie sehr fein zerstäubt werden und auch durch unterrichtete Beschichtung leicht die Kavitätenwände bedecken können.

Gemäß einer bevorzugten Ausführungsform eines Verfahrens zur Herstellung einer Leiterplatte gemäß der vorliegenden Erfindung kann es vorgesehen sein, dass beim Schritt des Herstellens der Kavität Abstand zu bestehenden Leiterzügen bzw. Bondoberflächen der Leiterplatte gehalten wird. Wenn gemäß dieser bevorzugten Ausführungsform des Herstellungsverfahrens die Kavität mit einem gewissen Abstand zu bestehenden Leiterzügen bzw. Bondoberflächen der Leiterplatte hergestellt wird, um das Aufbringen der Reflektorschicht in Gegenwart der temporären Schutzschicht vorzunehmen, ist sichergestellt, dass nach Entfernen der temporären Schutzschicht kein Kurzschluss ausgebildet wird, da die Schutzschicht die Leiterzüge bzw. Bondoberflächen entsprechend überlappt bzw. überragt.

Die Erfindung wird im Folgenden anhand eines in der Zeichnung schematisch dargestellten Ausführungsbeispiels näher erläutert. In dieser zeigen
- die Figuren 1a - 1f eine erste bevorzugte Ausführungsform des Verfahrens zur Herstellung einer Leiterplatte gemäß der Erfindung und
- die Figuren 2a - 2b eine alternative bevorzugte Ausführungsform des Verfahrens zur Herstellung einer Leiterplatte gemäß der Erfindung.

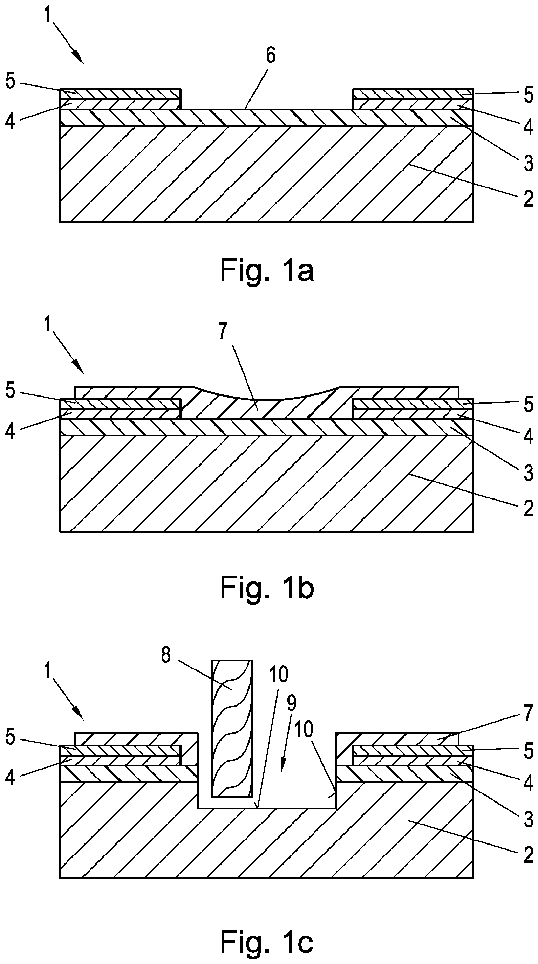

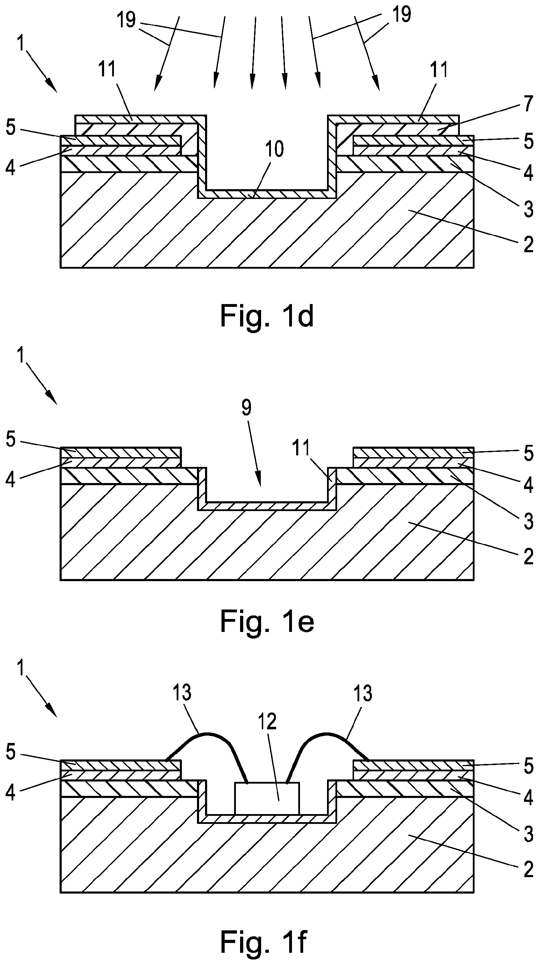

In Fig. 1a ist eine Leiterplatte mit 1 bezeichnet, wobei die Leiterplatte 1 im vorliegenden Fall eine IMS-Leiterplatte (Insulated Metal Substrate) ist. Die IMS-Leiterplatte 1 zeichnet sich durch ein relativ dickes Metallsubstrat 2 aus, welches aus Kupfer oder Aluminium gefertigt sein kann und eine Dicke von mindestens 50 µm bis zu einigen Millimetern aufweisen kann. Auf die Substratschicht 2 folgt eine Isolierschicht 3, die in der Regel aus einem isolierenden, mit thermisch leitfähigen Partikeln gefüllten Harzsystem, beispielsweise Epoxidharz, besteht. Auf dieser Isolierschicht 3 sind Leiterzüge 4 sowie Goldoberflächen 5, die als Bondoberflächen dienen, angeordnet. Die Leiterplatte 1 ist somit bereit zur Aufnahme von LED-Chips, die beispielsweise an der Position 6 angebracht werden könnten, wobei die Kontaktierung eines LED-Chips auf die Bondoberflächen 5 erfolgen könnte. Im Rahmen eines Verfahrens zur Herstellung einer Leiterplatte gemäß der vorliegenden Erfindung, bei der eine Kavität hergestellt werden soll, wird nun eine temporäre Schutzschicht 7 auf die Leiterplatte 1 aufgebracht (siehe Fig. 1b), die die Bondoberflächen 5 bedeckt. Die temporäre Schutzschicht 7 könnte darüber hinaus die Leiterzüge 4 aus Kupfer bedecken, wenn diese nicht wie im vorliegenden Fall von Goldoberflächen 5 bedeckt wären. In Fig. 1c ist nun zu erkennen, dass in der gemäß Fig. 1b vorbereitenden Leiterplatte, beispielsweise mittels eines Fräskopfes 8, eine Kavität 9 hergestellt werden kann. Die Kavität 9 weist nach diesem Verfahrensschritt relativ schlecht reflektierende Kavitätenwände 10 auf. Gemäß Fig. 1d wird nun die Reflektorschicht 11 aufgebracht, wie dies durch die Schar von Pfeilen 19 versinnbildlicht ist. Es ist zu erkennen, dass die Reflektorschicht 11 sowohl die temporäre Schutzschicht 7 als auch die Kavitätenwände 10 flächig bedeckt. Nach der Entfernung der temporären Schutzschicht 7 (siehe Fig. 1e) wird nun eine Leiterplatte mit einer verspiegelten Kavität 9 erhalten, wobei die Reflektorschicht 11 nur das Innere der Kavität 9 auskleidet. In die verspiegelte Kavität 9 kann nun ein LED-Chip 12 eingesetzt werden, der über Bonddrähte 13 an die Bondoberfläche 5 ankontaktiert werden kann (siehe Fig. 1f).

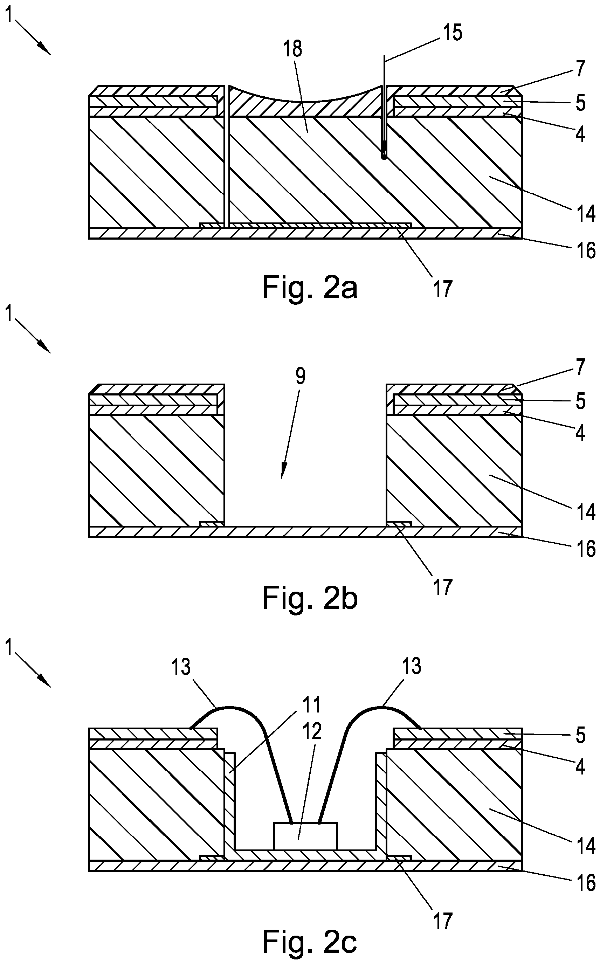

In Fig. 2a ist wiederum eine Leiterplatte 1 zu erkennen, die jedoch im vorliegenden Fall keine IMS-Leiterplatte, sondern eine Leiterplatte aus einem hinlänglich bekannten, glasfaserverstärkten Epoxidharz (z.B. FR4) ist. Die FR4-Schicht bzw. Prepreg-Schicht ist hierbei mit 14 bezeichnet, wobei wiederum Kupferlagen 4 und Bondoberflächen 5 auf der Leiterplatte 1 vorliegen. Mit 15 ist ein Laserstrahl versinnbildlicht, der sowohl durch die Schutzschicht 7 als auch durch die Prepreg-Schicht 14, die eine Isolierschicht darstellt, bis zum Auftreffen auf eine Laserstopplage 16, beispielsweise aus Kupfer, schneidet. Mit 17 ist eine haftvermindernde Schicht bezeichnet, die die Herauslösung des mittels des Laserstrahls 15 geschnittenen Pfropfens 18 erleichtert (siehe Fig. 2b). Der Zustand in Fig. 2b entspricht prinzipiell dem Zustand der Leiterplatte in Fig. 1c und es ist offensichtlich, dass die weitere Bearbeitung und die Herstellung der verspiegelten Kavität analog den Verfahrensschritten wie in den Figuren 1d bis 1f dargestellt, erfolgen kann, sodass letztendlich eine bestückte Leiterplatte wie in Fig. 2c ersichtlich erhalten werden kann.

Es ist offensichtlich, dass die vorliegende Erfindung nicht nur im Zusammenspiel mit LED-Chips eingesetzt werden, sondern auch für andere optoelektronische Komponenten, wie zum Beispiel für Photodioden oder Laserdioden ggf. zusammen mit einem Lichtkonversionsmittel, von Nutzen sein kann.

Weitere Aspekte der Erfindung umfassen Verfahren gemäß den folgenden Ausführungsformen bzw. Klauseln:
1. Eine erste Variante eines Verfahrens zur Herstellung einer erfindungsgemäßen Leiterplatte mit zumindest einer Kavität zur Aufnahme einer optoelektronischen Komponente, wobei die Kavitätenwände eine reflektierende, insbesondere spiegelnde Reflektorschicht aufweisen, kann die folgenden Schritte umfassen:
   - Bereitstellen einer Leiterplatte (1),
   - Aufbringen einer temporären Schutzschicht (7) auf zumindest einen Teilbereich der Oberfläche der Leiterplatte (1),
   - Herstellen der Kavität (9) unter Durchdringung der Schutzschicht (7) im Bereich der Kavität (9),
   - Aufbringen der Reflektorschicht (11), wobei die Reflektorschicht (1) sowohl die temporäre Schutzschicht (7) als auch die Kavitätenwände (10) flächig bedeckt,
   - Entfernen der temporären Schutzschicht (7).
2. Eine zweite Variante eines Verfahrens zur Herstellung einer erfindungsgemäßen Leiterplatte kann den Schritt umfassen, dass eine Leiterplatte (1) mit strukturierten Bondoberflächen (5) für elektronische Komponenten (12) bereitgestellt wird.
3. Eine dritte Variante eines Verfahrens zur Herstellung einer erfindungsgemäßen Leiterplatte kann den Schritt umfassen, dass als Leiterplatte (1) eine IMS-Leiterplatte (1) bereitgestellt wird.
4. Eine vierte Variante eines Verfahrens zur Herstellung einer erfindungsgemäßen Leiterplatte kann den Schritt des Herstellens der Kavität (9) das Fräsen der Leiterplatte (1) mit einem Fräskopf (8) umfassen.
5. Eine fünfte Variante eines Verfahrens zur Herstellung einer erfindungsgemäßen Leiterplatte kann den Schritt umfassen, dass als Leiterplatte (1) eine Leiterplatte (1) aus einem Prepreg-Material bereitgestellt wird.
6. Eine sechste Variante eines Verfahrens zur Herstellung einer erfindungsgemäßen Leiterplatte kann den Schritt des Herstellens der Kavität (9) mittels Schneiden der Leiterplatte (1) mit einem Laserstrahl (15) umfassen.
7. Eine siebente Variante eines Verfahrens zur Herstellung einer erfindungsgemäßen Leiterplatte kann das Bereitstellen einer Leiterplatte, wobei die Leiterplatte (1) eine über einer Laserstopplage (16) angeordnete haftvermindernde Schicht (17) aufweist, umfassen.
8. Eine achte Variante eines Verfahrens zur Herstellung einer erfindungsgemäßen Leiterplatte kann den Schritt umfassen, dass als temporäre Schutzschicht (7) eine selbstklebende Folie aufgebracht wird.
9. Eine neunte Variante eines Verfahrens zur Herstellung einer erfindungsgemäßen Leiterplatte kann den Schritt umfassen, dass als temporäre Schutzschicht (7) eine selbstklebende Folie aufgebracht wird, wobei die selbstklebende Folie eine Folie auf Polyethylenbasis mit einer Klebeschicht auf Kautschukbasis ist.
10. Eine zehnte Variante eines Verfahrens zur Herstellung einer erfindungsgemäßen Leiterplatte kann den Schritt umfassen, dass als temporäre Schutzschicht (7) eine selbstklebende Folie aufgebracht wird, wobei die selbstklebende Folie eine Folie auf PVC-Basis mit einer Klebeschicht auf Acrylatbasis ist.
11. Eine elfte Variante eines Verfahrens zur Herstellung einer erfindungsgemäßen Leiterplatte kann den Schritt umfassen, dass als temporäre Schutzschicht (7) eine selbstklebende Folie aufgebracht wird, wobei die selbstklebende Folie eine Folie auf Polyethylenbasis mit einer Klebeschicht auf Acrylatbasis ist.
12. Eine zwölfte Variante eines Verfahrens zur Herstellung einer erfindungsgemäßen Leiterplatte kann den Schritt umfassen, dass als temporäre Schutzschicht (7) ein Lack auf Silikonbasis aufgebracht wird.
13. Eine dreizehnte Variante eines Verfahrens zur Herstellung einer erfindungsgemäßen Leiterplatte kann den Schritt umfassen, dass die Reflektorschicht (11) aus einem Lack, ausgewählt aus der Gruppe bestehend aus Epoxidlacken und Acrylatlacken, gebildet wird.
14. Eine vierzehnte Variante eines Verfahrens zur Herstellung einer erfindungsgemäßen Leiterplatte kann den Schritt umfassen, dass beim Herstellen der Kavität (9) Abstand zu bestehenden Leiterzügen (4) bzw. Bondoberflächen (5) der Leiterplatte (1) gehalten wird.

## Patentansprüche

1. Leiterplatte (1), wobei die Leiterplatte (1) an ihrer Leiterplattenoberfläche zumindest eine strukturierte Bondoberfläche (5) zum Ankontaktieren für optoelektronische Komponenten (12) aufweist, und wobei die Leiterplatte (1) zumindest eine Kavität (9) zur Aufnahme einer optoelektronischen Komponente (12) aufweist, wobei Kavitätenwände (10) in der zumindest einen Kavität (9) eine reflektierende, insbesondere spiegelnde, Reflektorschicht (11) aufweisen, **dadurch gekennzeichnet, dass** selektiv nur die Kavitätenwände (10) im Inneren der Kavität (9) mit der Reflektorschicht (11) beschichtet sind, wobei die Reflektorschicht (11) eine Lackbeschichtung ist.

2. Leiterplatte (1) nach Anspruch 1, **dadurch gekennzeichnet, dass** die Reflektorschicht (11) aus einem Lack ausgewählt aus der Gruppe bestehend aus Epoxidlacken und Acrylatlacken, gebildet ist.

3. Leiterplatte (1) nach Anspruch 1 oder 2, **dadurch gekennzeichnet, dass** die Reflektorschicht (11) aus einem Lötstopplack gebildet ist, wobei der Lötstopplack vorzugsweise weiße Pigmente enthält.

4. Leiterplatte (1) nach einem der Ansprüche 1 bis 3, **dadurch gekennzeichnet, dass** die Reflektorschicht (11) aus einem nicht leitenden Material hergestellt ist.

5. Leiterplatte (1) nach einem der Ansprüche 1 bis 4, **dadurch gekennzeichnet, dass** die Leiterplatte (1) eine IMS-Leiterplatte (1) ist.

6. Leiterplatte (1) nach Anspruch 5, **dadurch gekennzeichnet, dass** die IMS-Leiterplatte (1) eine Substratschicht (2) eines Metallsubstrats, eine Isolierschicht (3), die auf die Substratschicht (2) folgt, sowie Leiterzüge (4) umfasst, wobei die Leiterzüge (4) auf der Isolierschicht (3) sowie unterhalb der strukturierten Bondoberfläche (5) angeordnet sind.

7. Leiterplatte (1) nach einem der Ansprüche 1 bis 4, **dadurch gekennzeichnet, dass** die Leiterplatte (1) aus einem Prepreg-Material (14) hergestellt ist.

8. Leiterplatte (1) nach Anspruch 7, **dadurch gekennzeichnet, dass** die Leiterplatte (1) mehrschichtig aufgebaut ist und Leiterzüge (4) umfasst, die unterhalb der strukturierten Bondoberfläche (5) angeordnet sind.

9. Leiterplatte (1) nach einem der Ansprüche 1 bis 8, **dadurch gekennzeichnet, dass** eine Laserstopplage (16) einen Boden der zumindest einen Kavität (9) bildet.

10. Leiterplatte (1) nach einem der Ansprüche 1 bis 9, weiterhin umfassend eine temporäre Schutzschicht (7), die dazu vorgesehen ist, Leiterbahnen und empfindliche Bondoberflächen vor Beschmutzungen und Beschädigungen zu schützen, **dadurch gekennzeichnet, dass** die temporäre Schutzschicht (7) so aufgebracht ist, dass diese die zumindest eine strukturierte Bondoberfläche (5) bedeckt, wobei die Reflektorschicht (1) sowohl die temporäre Schutzschicht (7) als auch die Kavitätenwände (10) im Inneren der zumindest einen Kavität (9) flächig bedeckt, und wobei die temporäre Schutzschicht (7) mechanisch durch Abziehen von der strukturierten Bondoberfläche (5) entfernbar ist.

11. Leiterplatte (1) nach Anspruch 10, **dadurch gekennzeichnet, dass** die temporäre Schutzschicht (7) so angeordnet ist, dass diese exakt bis an den Rand der zumindest einen Kavität (9) heranreicht.

12. Leiterplatte (1) nach einem der Ansprüche 1 bis 11, weiterhin umfassend zumindest eine optoelektronische Komponente (12), **dadurch gekennzeichnet, dass** die zumindest eine optoelektronische Komponente (12), vorzugsweise zusammen mit einem Lichtkonversionsmittel, in der zumindest einen Kavität (9) aufgenommen ist.

13. Leiterplatte (1) nach Anspruch 12, **dadurch gekennzeichnet, dass** die zumindest eine optoelektronische Komponente (12), vorzugsweise über Bonddrähte (13), an die freigelegte strukturierte Bondoberfläche (5) ankontaktiert ist.

14. Leiterplatte (1) nach Anspruch 12 oder 13, **dadurch gekennzeichnet, dass** die zumindest eine optoelektronische Komponente (12) ausgewählt ist aus der Gruppe bestehend aus: LED-Chip, Photodiode, Laserdiode.
